# EUROPEAN PATENT APPLICATION

(11) **EP 3 843 109 A1**
(43) Date of publication of application: **30.06.2021**
(21) Application number: 19383185.6
(22) Date of filing: 23.12.2019
(51) Int. Cl.: H01B 1/12, H01L 51/00, C08G 61/02

(54) **PERIACENE BIRADICAL POLYMERS**

(71) Applicant: Fundación Imdea Nanociencia, 28049 Madrid (ES); Universidad Complutense De Madrid, 28040 Madrid (ES); Fyzikální ústav AV CR, v.v.i., 18221 Praha 8 (CZ)
(72) Inventor: ÉCIJA FERNÁNDEZ, David, E-28049 Madrid (ES); URGEL TENDERO, José Ignacio, E-28049 Madrid (ES); LAUWAET, Koen, E-28049 Madrid (ES); SÁNCHEZ GRANDE, Ana, E-28049 Madrid (ES); MIRANDA SORIANO, Rodolfo, E-28049 Madrid (ES); MARTÍN LEÓN, Nazario, E- 28015 Madrid (ES); SANTOS BARAHONA, José Manuel, E- 28015 Madrid (ES); JELÍNEK, Pavel, 182 21 Prague 8 (CZ)
(74) Representative: ABG Intellectual Property Law, S.L.

(57) **Abstract**

The present invention refers to a periacene π-conjugated biradical polymer of formula (I), to a method for its synthesis and uses therefrom. The biradical π-conjugated polymers have quinoid-like character, based on periacene monomers linked through cumulene bridges featuring semiconductor behavior.

## Description

### FIELD OF THE INVENTION

The present invention relates generally to π-conjugated polymers, their synthesis and uses thereof. In particular, the invention relates to the field of biradical π-conjugated polymers with quinoid-like character, based on periacene monomers linked through cumulene bridges featuring semiconductor behavior.

### BACKGROUND

Hydrocarbons which are formed by linear annellation of benzene rings, i.e. linearly-fused benzene rings, are called "acenes". In the context of the present invention, an *n-*acene is an acene comprising *n* linearly-fused benzene rings.

Peri-condensation of n-acenes leads to polycyclic aromatic hydrocarbons (PAHs), characterized by zigzag and armchair edges in their periphery as represented below.

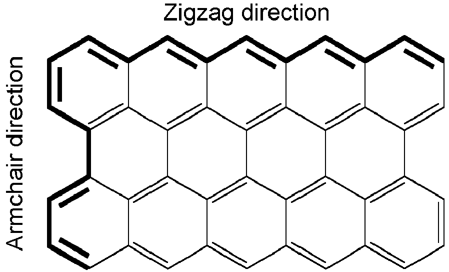

Such PAHs can be further identified as m-peri-n-acenes or [m,n]-periacenes, wherein m is the number of outer benzenoid rings along the armchair direction and the index *n* is the number of outer benzenoid rings along the zigzag direction. For instance, the exemplary compound depicted above can be identified as [3,5]-periacene or as peripentacene. Pentacene is a polycyclic aromatic hydrocarbon consisting of five linearly-fused benzene rings. This exemplary compound is a PAH resulting from the condensation of 2 pentacene molecules.

[*m,n*]-periacenes represent a family of open-shell PAHs formed through the edgewise fusion of two or more *n*-acenes, wherein when two *n*-acenes are fused, the resulting structure can also be seen as the smallest well-defined graphene fragments with unpaired electron densities containing both high-symmetry edge topologies of graphene.

The presence of unpaired electrons in their structure makes periacenes model systems to study the onset and evolution of various exotic physical properties predicted in graphene. Theoretical studies have predicted a significant decrease in the electronic gap with increasing size, a spin-polarized ground state with fast evolution toward a polyradical state, and half-metallicity under external electric fields. Based on these edge-related spin-polarized properties, they have received increased attention in recent years due to potential applications in molecular electronic devices.

Plasser F. et al., Angew. Chem. Int. Ed. 2013, 52, 2581-2584 investigate the properties of different PAHs at the theoretical level.

An atomically precise manageable fabrication of nanoarchitectures is an appealing concept of modern nanotechnology. The construction of innovative materials such as molecular electronic and spintronic devices requires the controllable arrangement and connections between the molecular counterparts in a clean environment designed and produced with atomic precision. One-dimensional polymers or graphene nanoribbons (GNRs) have been synthesized in solution or via top-down approaches and applied for several applications.

However, their synthesis via solution-based chemistry is challenging as a result of the high inherent reactivity, which arises from unpaired electron densities. In addition, standard top-down fabrication techniques such as lithography, etching, block copolymer mask or using nanoparticles as templates are not appropriate for the fabrication of homogeneous structures with the required atomic size and precision due to the breaking of chemical bonds inherent to these fabrication methods, compromising the edges of the polymer nanostructures with little control over the orientation.

Under this scenario, on-surface synthesis, based on a bottom-up approach, allows the investigation of surface-driven catalytic reactions of rationally designed stable precursor molecules under ultrahigh vacuum (UHV) conditions. Therefore, such experimental approach provides an advantageous synthetic toolbox toward atomically precise synthesis of PAHs hitherto elusive via solution chemistry, enabling the atomic-scale study of structural and electronic properties using scanning probe microscopies.

The incorporation of such compounds as monomers in one-dimensional polymers opens new avenues to the fabrication of atomically precise radicalic π-conjugated polymers with prospects in organic spintronics, nonlinear optics and photovoltaics.

In this context, the work by Ana Sanchez-Grande et al., Angew. Chem. Int. Ed. 2019, 58, 6559-6563 reports on the on-surface synthesis for the production of poly(p-anthracene ethynylene) molecular wires on Au(111) surfaces, by means of thermally activated dehalogenation of a dibromide PAH precursor and homocoupling. The molecular wires of this work are characterized by individual anthracene monomers linked by ethynylene bridges that boast a band gap of 1.5 eV.

However, despite the low band gap of reported linear periacene-based PAH polymers, none of them exhibit a radical open-shell nature at each end of the polymers.

PAH polymers offer a wide range of optical and electronic properties attractive for semiconducting applications. However, despite its potential, there is still a need in the art to provide polymers based on periacenes with semiconductor behavior for real devices because they are simply not stable enough. In this sense, the work by Koike, H. et al., Adv. Funct. Mater., 2015, 26, 277-283 report on delocalized singlet biradical hydrocarbons and the manufacture of Organic Field-Effect Transistors (OFETs) by gas deposition.

### SUMMARY OF THE INVENTION

Building on the prior art necessity to provide polymers based on periacenes with semiconductor behavior for real devices, the present invention relates to one-dimensional biradical polymer structures based on periacene monomers, their synthesis and their uses. Particularly, up to this date, there was still a need in the art to provide a polymer which has a stable biradical state, one radical at each of the terminal ends, i.e., exhibiting pronounced open-shell character yet possessing remarkable stability.
In particular, the present invention relates to one-dimensional π-conjugated biradicaloid polymers based on periacene units with quinoid-like character, which are linked to each other through a cumulene bridge, whose overall π-topology determines the formation of a radical state at both ends of the polymer. This effect leads to a biradicaloid polymer featuring semiconductor behavior with narrow bandgap.
The inventors have synthesized a π-conjugated periacene polymer and surprisingly noted that a radical state is present at each of the two ends of the polymer.

In a first aspect, the invention is directed to a π-conjugated polymer of formula (I): 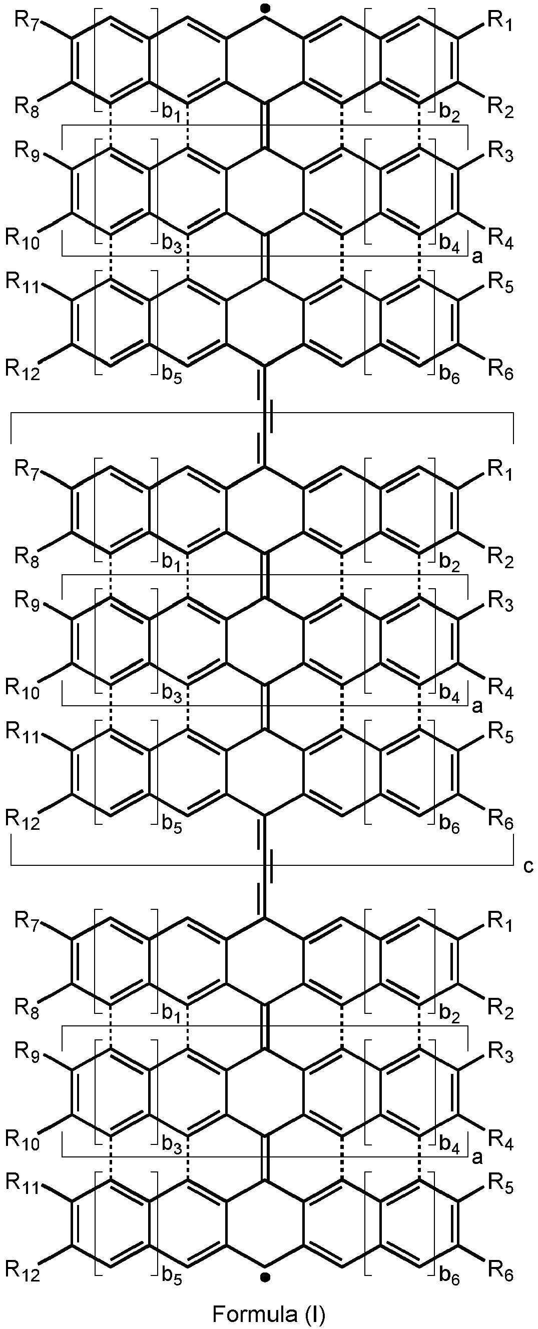 wherein,
each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl;
each occurrence of the integer a is independently selected from 0, 1 or 2;
each occurrence of the integers **b₁, b₂, b₃, b₄, b₅** and **b₆** is independently selected from 0, 1, 2, 3 or 4 wherein **b₁** + **b₂** is ≤ 4, **b₃** + **b₄** is ≤ 4, **b₅** + **b₆** is ≤ 4 and **b₁** + **b₂** + **b₃** + **b₄** + **b₅** + **b₆** > 0;
c is an integer comprised between 0 and 100;
each occurrence of the dashed bonds inside each monomer unit is independently a bond or absence of a bond; and
each circular dot depicted next to the terminal carbon atoms represents one unpaired electron.

A second aspect of the invention consists of a method for the synthesis of a π-conjugated polymer which comprises the steps of:
a. providing, on a solid substrate, at least two polycyclic aromatic hydrocarbon monomer precursor units of formula (II), 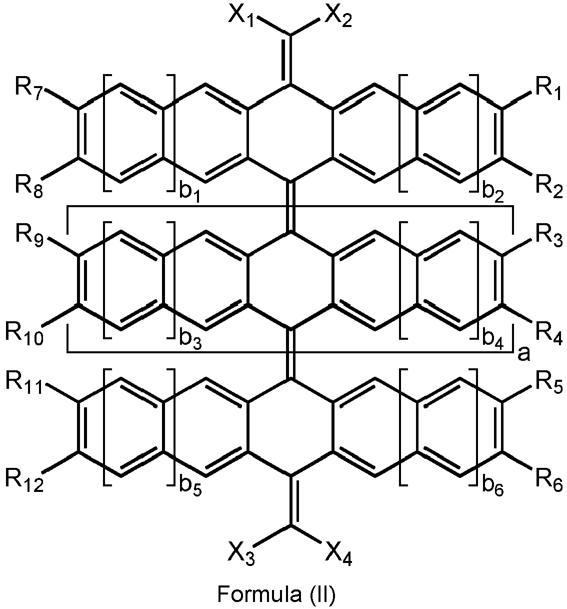 wherein,
   **R₁, R₂, R₃, R₄, R₅, R₆, R₇, R₈, R₉, R₁₀, R₁₁** and **R₁₂** are independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl;
   the integer a is selected from 0, 1 or 2;
   the integers **b₁, b₂, b₃, b₄, b₅** and **b₆** are independently selected from 0, 1, 2, 3 or 4 wherein **b₁** + **b₂** is ≤ 4, **b₃** + **b₄** is ≤ 4, **b₅** + **b₆** is ≤ 4 and **b₁** + **b₂** + **b₃** + **b₄** + **b₅ + b₆** > 0; and
   **X₁, X₂, X₃** and **X₄** is independently selected from a leaving group consisting of I, Br, Cl, F, sulfonate, phosphonate, boronate, azo, silane or stannane, preferably Br;
b. polymerizing the monomer precursor of the previous step on the solid substrate by dehalogenation and subsequent C-C coupling; and
c. at least partially cyclodehydrogenating the polymer obtained in the previous step.

In a third aspect of the invention, a π-conjugated polymer obtainable according to the method of the second aspect of the invention is provided.

In a fourth aspect, the invention is directed at the use of the π-conjugated polymer of the invention, in semi-conductors, light-emitting devices, photovoltaics, organic field-effect transistors, photocatalysis, sensors, organic spintronics, near infrared, nonlinear optics and topological quantum memories.

### DESCRIPTION OF THE DRAWINGS

These and other characteristics and advantages of the invention will become clearly understood in view of the detailed description of the invention which becomes apparent from a preferred embodiment of the invention, given just as an example and not being limited thereto, with reference to the drawings.

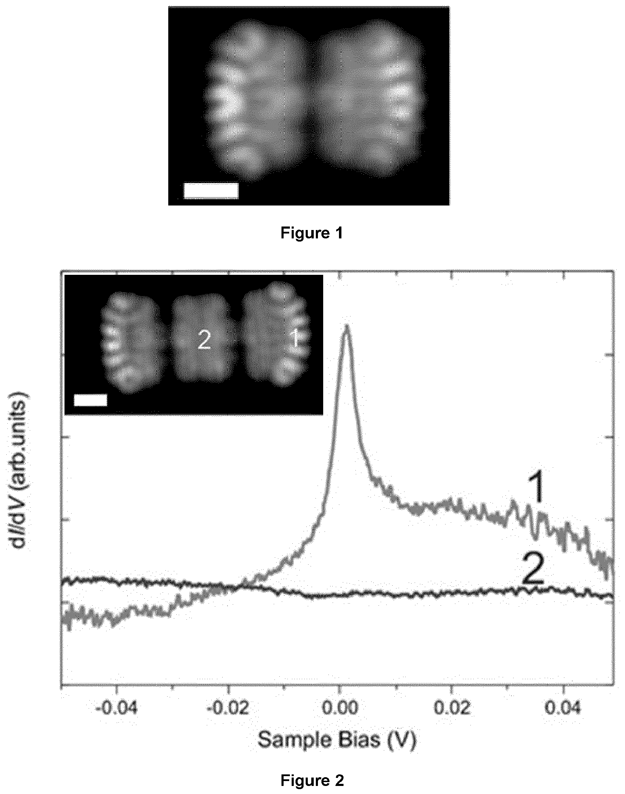

Figure 1: Scanning tunneling microscopy (STM) image (at constant height at V_{bias}= 3 mV) of an exemplary polymer of the invention comprising two monomer units wherein each monomer is a [3,5]-periacene, i.e., wherein **c** is 0, **a** is 0, and **b₁, b₂, b₅** and **b₆** are 1. The value of the scale bar is 0.5 nm.
Figure 2: Comparison scanning tunneling spectroscopy (STS) data taken at the end of the polymer of the invention and at its middle in the UHV system at a pressure of 3×10⁻¹⁰ mbar. The inset shows an STM image (at constant height at V_{bias}= 3 mV) of an exemplary polymer of the invention comprising three monomer units wherein each monomer is a [3,5]-periacene, i.e., wherein **c** is 1, **a** is 0, and **b₁, b₂, b₅** and **b₆** are 1. The value of the scale bar is 0.5 nm.

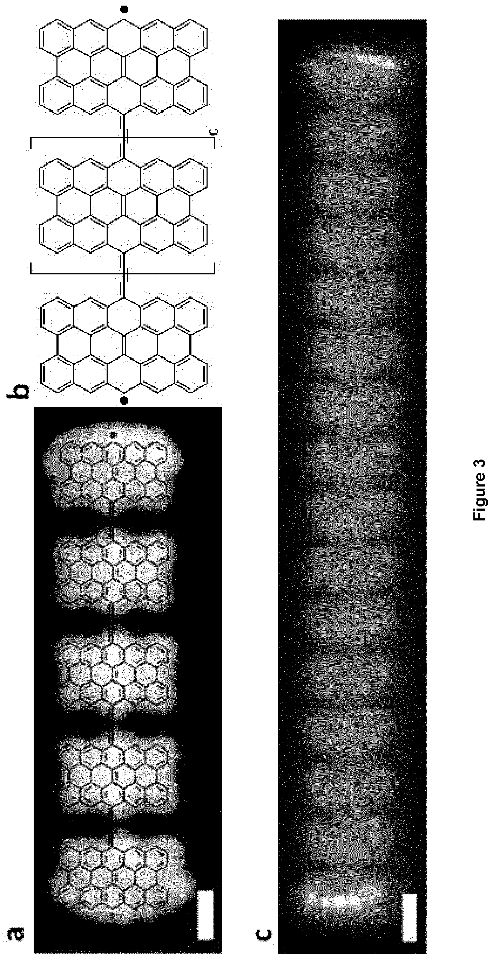

Figure 3: a. STM image (at constant height at V_{bias}= 3 mV) of an exemplary polymer of the invention comprising five monomer units wherein each monomer is a [3,5]-periacene, i.e., wherein **c** is 3, **a** is 0, and **b₁, b₂, b₅** and **b₆** are 1. The value of the scale bar is 0.5 nm. b. Chemical formula according to formula (I) showing a general peripentacene polymer linked by cumulene bridges with biradical character. c. STM image (at constant height at V_{bias}= 3 mV) of an exemplary polymer of the invention comprising 16 monomer units wherein each monomer is a [3,5]-periacene, i.e., wherein **c** is 14, **a** is 0, and **b₁, b₂, b₅** and **b₆** are 1. The value of the scale bar is 1 nm.

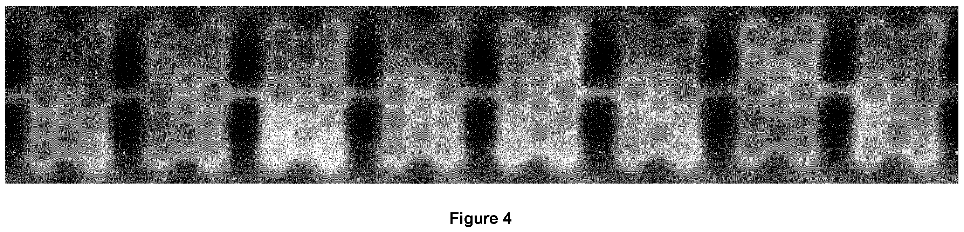

Figure 4: Constant height non-contact AFM image of an exemplary polymer of the invention, comprising 16 monomer units wherein each monomer is a [3,5]-periacene, i.e., wherein **c** is 14, **a** is 0, and **b₁, b₂, b₅** and **b₆** are 1.

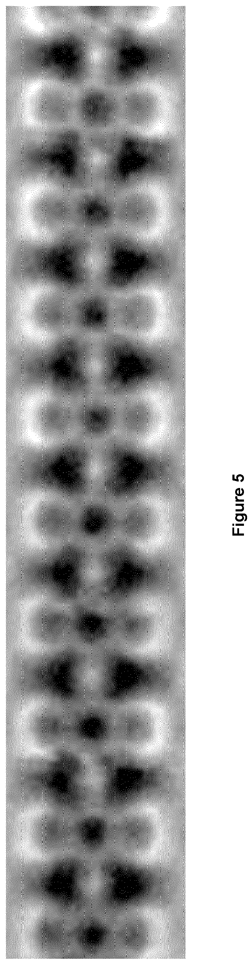

Figure 5: Constant height non-contact AFM image of a comparative polymer.

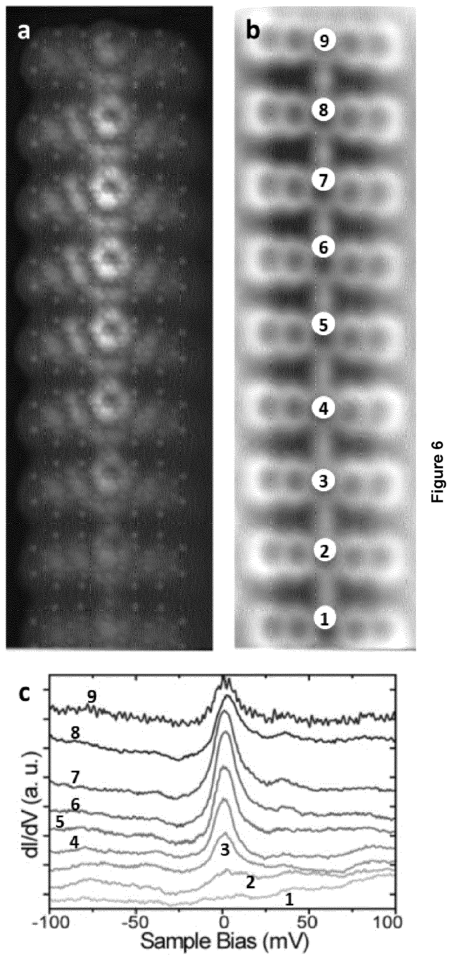

Figure 6: a. STM image (at constant height at V_{bias}= 3 mV) of a comparative polymer. b. Constant height non-contact AFM of a comparative polymer. The numbers identify the points measured as shown in each curve of figure 6c. c. STS data taken at different regions of the comparative monomers (wherein each of the numbers identify the location shown in figure 6b) in the UHV system at a pressure of 3×10⁻¹⁰ mbar.

### DETAILED DESCRIPTION OF THE INVENTION

Unless defined otherwise, all technical and scientific terms used herein have the same meaning as commonly understood to one of ordinary skill in the art to which this disclosure belongs.

Unless defined otherwise, any representation of molecular structures is to be interpreted as what the inventors have observed to be the most stable resonance form. The skilled person will readily understand that in a compound comprising a π-conjugated systems, different depictions of resonance structures may adequately describe the same system.

Unless defined otherwise, when a numerical value is provided, it contemplates both the exact value disclosed and the rounded value to the last disclosed decimal. For example, the value 2 includes any value comprised in the range between 1.5 and 2.4. In turn, the value 1.5 includes any value comprised in the range between 1.45 and 1.54.

### π-conjugated polymer

In a first embodiment, the invention is directed at a π-conjugated polymer of formula (I): 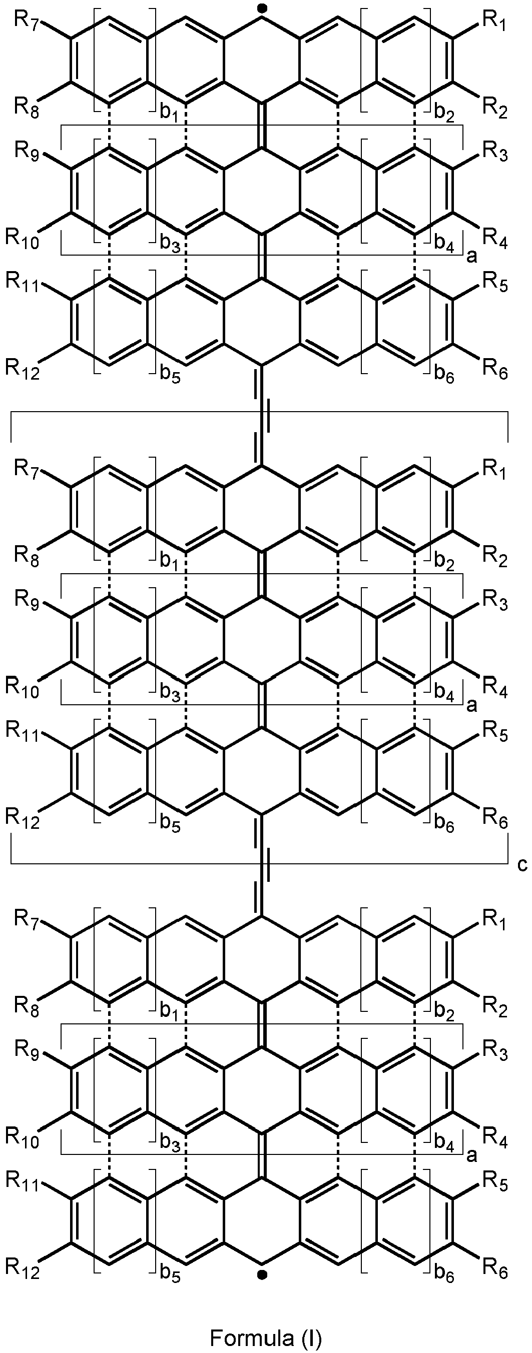 wherein,
each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl;
each occurrence of the integer a is independently selected from 0, 1 or 2;
each occurrence of the integers **b₁, b₂, b₃, b₄, b₅** and **b₆** is independently selected from 0, 1, 2, 3 or 4 wherein **b₁** + **b₂** is ≤ 4, **b₃ + b₄** is ≤ 4, **b₅** + **b₆** is ≤ 4 and **b₁** + **b₂** + **b₃** + **b₄** + **b₅** + **b₆** > 0;
**c** is an integer comprised between 0 and 100;
each occurrence of the dashed bonds inside each monomer unit is independently a bond or absence of a bond; and
each circular dot depicted next to the terminal carbon atoms represents one unpaired electron.

The inventors have surprisingly found that the most stable of the polymer's resonance forms is characterized by the presence of one unpaired electron at each of the two termini of the polymer. The polymer is therefore a biradical polymer.

A biradical is an even-electron chemical compound with two free radical centers which act independently of each other.

The assumption that the polymer has a biradical character is supported by the experimental data shown in the Examples and Figures below. In the present case, there is a clear preference towards the resonance structure comprising the biradical at the termini of the polymer.

In addition, the stabilization of the structure with appearance of the biradical is accompanied by the formation of cumulene bridges between the monomers.

In a particular embodiment, the polymer of the invention is such that the monomers are bridged by cumulene (=C=C=) bonds. In a preferred embodiment, all of the monomers are bridged by cumulene bonds. In other words, in a preferred embodiment, the biradical polymer structure presents c periacene repeating units which are bridged with neighboring periacenes via cumulene-like bonds.

In a particular embodiment, the biradical polymer of the invention presents extended aromaticity at least along the transverse direction of the periacene repeating units. In the context of the present invention, the transverse direction is the direction which is orthogonal to the polymer's length.

The longitudinal direction is the direction spanning the length of the polymer, i.e., from one terminal monomer to the other terminal monomer on the opposite side of the linear polymer.

In a preferred embodiment of the invention, the biradical polymer is stable as a singlet state.

In another embodiment, the polymer of the invention is a defect-free polymer. In the context of the present invention, "defect-free" is used to describe that the bonds in the entire polymer are as depicted in formula (I), or its resonance alternative forms, without the presence of excised bonds, open rings or ring fusions. In a particular embodiment, the synthesis of the polymer of the invention does not lead to any side reactions.

### Polymers of Formula (I)

Except if stated otherwise, when ranges are provided, explicitly indicated limit values of ranges are to be included in the range.

In formula (I), each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl.

The term "optionally substituted" means that the relevant group is either unsubstituted or substituted with a substituent selected from halogen, hydroxyl, linear or branched C₁₋₆ alkyl, C₃₋₇ cycloalkyl, C₆₋₁₅ aryl, C₁₋₆ alkyl(C₆₋₁₀)aryl, -COR_{b}, or -COOR_{c}, wherein R_{b} and R_{c} are independently selected from H, C₁-C₆ alkyl, halo(C₁-C₆ alkyl), C₃-C₇ cycloalkyl, 3- to 10-membered heterocyclyl, C₆-C₁₂ aryl, (C₆-C₁₂)aryl(C₁-C₆)alkyl, or 3-to 10-membered heteroaryl.

In a preferred embodiment, each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, - CN, -NO₂, optionally substituted C₆-C₁₂ aryl and optionally substituted 3- to 10-membered heteroaryl.

In another preferred embodiment, each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN and -NO₂

In a particular embodiment, each occurrence of **R₁, R₂, R₃, R₄, R₅, R₆, R₇, R₈, R₉, R₁₀, R₁₁** and **R₁₂** is H, OH, -CN, -NO₂, optionally substituted C₁-C₆ alkyl group or optionally substituted C₆-C₁₂ aryl. Preferably, each occurrence of **R₁, R₂, R₃, R₄, R₅, R₆, R₇, R₈, R₉, R₁₀, R₁₁** and **R₁₂** is H, OH, optionally substituted C₁-C₆ alkyl group or optionally substituted benzene.

In a particular embodiment **R₁, R₂, R₃, R₄, R₅, R₆, R₇, R₈, R₉, R₁₀, R₁₁** and **R₁₂** are H.

In formula (I), each occurrence of the integer a is independently selected from 0, 1 or 2. Preferably, each occurrence of the integer a is independently selected from 0 or 1.

In formula (I), each occurrence of the integers **b₁, b₂, b₃, b₄, b₅** and **b₆** is independently selected from 0, 1, 2, 3 or 4 wherein **b₁** + **b₂** is ≤ 4, **b₃** + **b₄** is ≤ 4, **b₅** + **b₆** is ≤ 4 and **b₁** + **b₂** + **b₃** + **b₄** + **b₅** + **b₆** > 0.

In a preferred embodiment, at least one of **b₁ + b₂, b₃** + **b₄** or **b₅** + **b₆** is ≥ 2.

Preferably, each occurrence of the integers **b₁, b₂, b₃, b₄, b₅** and **b₆** is independently selected from 0, 1 or 2, preferably from 1 or 2. In a preferred embodiment, **b₁, b₂, b₃, b₄, b₅** and **b₆** are 1.

In a particular embodiment, **b₁** + **b₂** is ≤ 3, **b₃ + b₄** is ≤ 3, or **b₅** + **b₆** is ≤ 3.

In another particular embodiment, **b₁** + **b₂** is ≤ 2, **b₃ + b₄** is ≤ 2, or **b₅** + **b₆** is ≤ 2.

In yet another particular embodiment, **b₁** + **b₂** is ≤ 1, **b₃ + b₄** is ≤ 1, or **b₅** + **b₆** is ≤ 1.

In a particular embodiment, **b₁** + **b₂** + **b₃** + **b₄** + **b₅** + **b₆** ≥ 2, preferably ≥ 3, more preferably ≥ 4.

In formula (I), integer c represents the number of monomer repeating units. In a particular embodiment, c is an integer comprised between 0 and 100, between 0 and 90, between 0 and 80, between 0 and 70, more preferably between 0 and 60, even more preferably between 0 and 50. In a most preferred embodiment, c is an integer comprised between 0 and 40.

The techniques available for determining the number of monomer units are readily available to the skilled person, exemplary techniques being GPC or NMR. An exemplary report on how to determine molecular weight is found in Josephat U. Izunobi and Clement L. Higginbotham, J. Chem. Educ. 2011, 88, 1098-1104*.*

In the context of the present invention, a repeating unit is to be understood as synonym to a monomer.

In a particular embodiment, each monomer or repeating unit, including the terminal monomers, is a monomer wherein at least 30%, at least 35%, preferably at least 40%, of the edge carbons are zigzag edge carbons. In this context, in the exemplary case of the [3,5]-periacene monomer, the number of zigzag edge carbon atoms is 22 while the number of armchair edge carbon atoms is 16, which means that 58% of the edge carbon atoms are zigzag edge carbon atoms. The number of edge carbon atoms and their type can be measured and assigned by means of, for example, non-contact AFM or Raman spectroscopy.

The number of fused benzene rings in each acene unit of each monomer is defined by the sums **b₁** + **b₂, b₃** + **b₄** or **b₅** + **b₆,** and this sum is what determines the polymer's width. In a particular embodiment, the repeating units of the polymer of the invention are characterized by a width, i.e., the distance resulting from the sum of the fused benzene rings, comprised between 1 nm and 3 nm, preferably from 1.4 to 2.5 nm.

In a preferred embodiment, the polymer of the invention is a linear polymer. In the context of the present invention, linear polymer means that the polymer is the result of a polymerization reaction that follows a linear path. In other words, the polymer forms a straight chain, not a branched chain.

In a particular embodiment, the biradical [*m,n*]-periacene polymer structure of the invention is characterized by a thickness or height equal to that of one single atom. Preferably, the polymer has a thickness determined by the thickness of benzene. In this context, thickness is the third 3D dimension where width and length are the other two.

In formula (I), each occurrence of the dashed bonds inside each monomer unit is independently a bond or absence of a bond. Depending on the duration of the cyclodehydrogenation reaction of the method of the invention, each monomer (including the terminal monomer units) will be from partially to fully cyclodehydrogenated.

In a particular embodiment, the percentage of fully cyclodehydrogenated monomers (i.e., the percentage of monomers in the polymer wherein all of the dash bonds in formula (I) are solid bonds) is at least 1%, at least 2%, at least 3%, at least 4%, at least 5%, at least 10%, at least 15%, at least 20%, at least 30%, at least 40%, at least 50%, at least 60%, at least 70%, at least 80%, at least 85%, at least 90%, at least 95%, at least 96%, at least 98%.

In a particular embodiment, the polymer of the invention is a stable polymer. In a more preferred embodiment, the polymer of the invention is a stable polymer under air. In an even more preferred embodiment, the polymer of the invention is a stable polymer under air, at ambient pressure and at room temperature.

The term "stable" is to be understood as meaning that the polymer of the invention, after its synthesis, remains as a biradical polymer for at least 1 hour, 3 hours, 6 hours, 12 hours, 24 hours, 2 days, 15 days, 30 days, preferably 6 months, more preferably 1 year.

Non-limiting exemplary polymers that fall into the scope of formula (I) are:

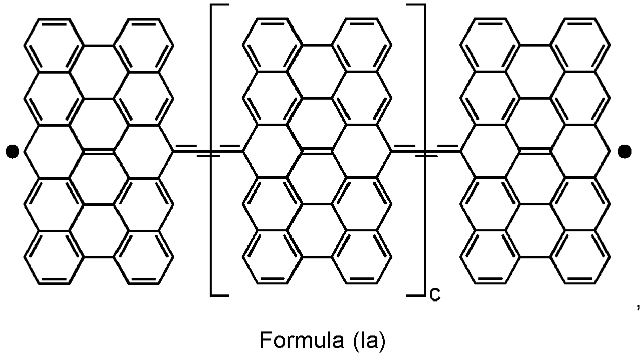

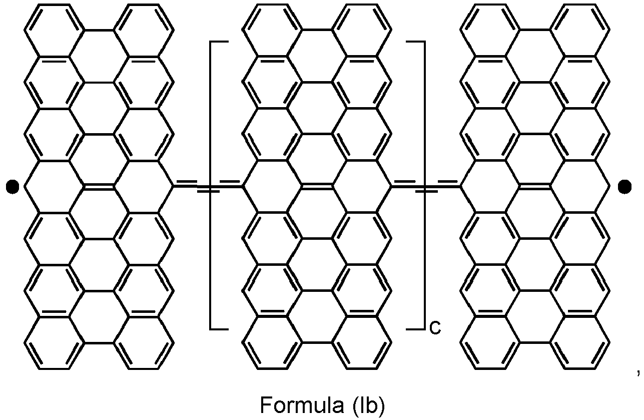

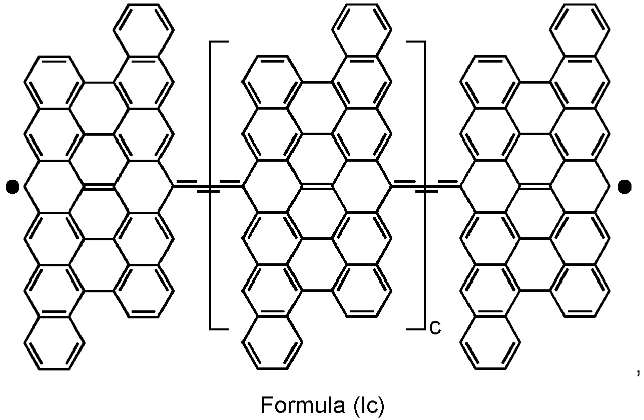

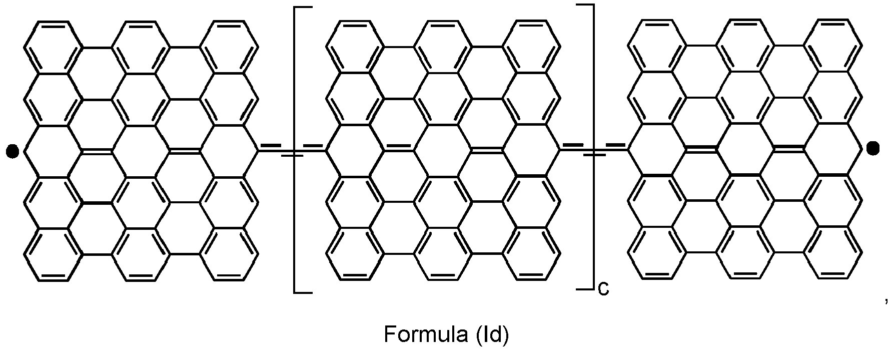

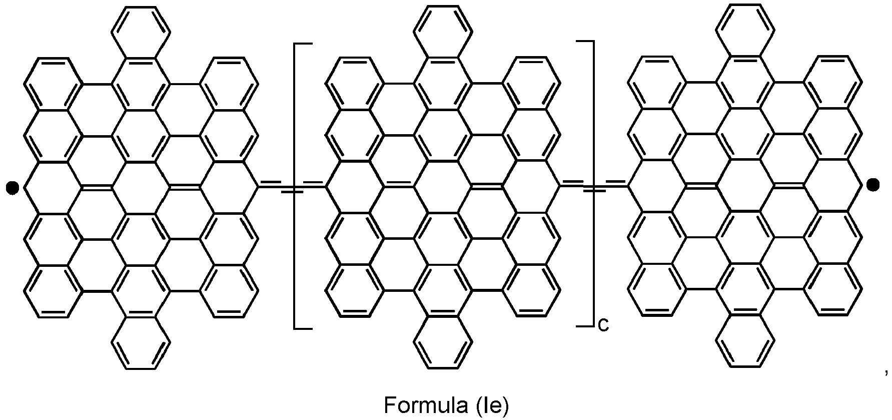

### Method of the invention

The second aspect of the invention consists in a method for the synthesis of a π-conjugated polymer which comprises the steps of:
a. providing, on a solid substrate, at least two polycyclic aromatic hydrocarbon monomer precursor units of formula (II), 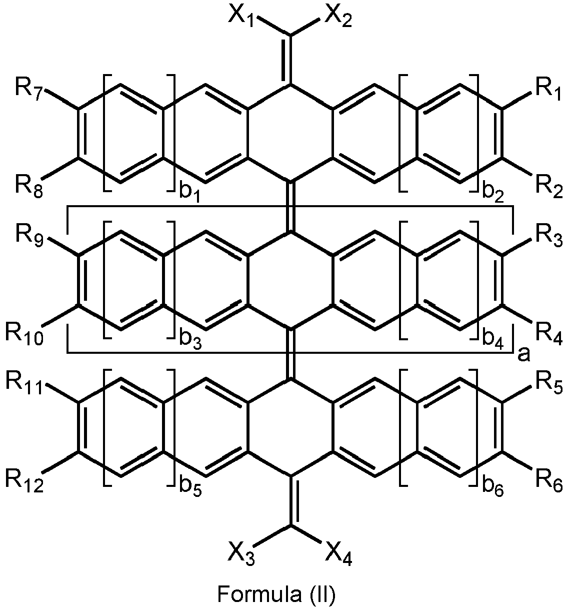 wherein,
   **R₁, R₂, R₃, R₄, R₅, R₆, R₇, R₈, R₉, R₁₀, R₁₁** and **R₁₂** are independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl;
   the integer a is selected from 0, 1 or 2;
   the integers **b₁, b₂, b₃, b₄, b₅** and **b₆** are independently selected from 0, 1, 2, 3 or 4 wherein **b₁** + **b₂** is ≤ 4, **b₃** + **b₄** is ≤ 4, **b₅** + **b₆** is ≤ 4 and **b₁** + **b₂** + **b₃** + **b₄** + **b₅ + b₆** > 0; and
   **X₁, X₂, X₃** and **X₄** is independently selected from a leaving group consisting of I, Br, Cl, F, sulfonate, phosphonate, boronate, azo, silane or stannane, preferably Br;
b. polymerizing the monomer precursor of the previous step on the solid substrate by dehalogenation and subsequent C-C coupling; and
c. at least partially cyclodehydrogenating the polymer obtained in the previous step.

The method of the invention provides a convenient method based on the on-surface bottom-up approach for the manufacture of biradical [*m,n*]-periacene polymers in an atomically reproducible way.

Steps (a) to (c) lead to the formation of biradical [*m,n*]-periacene polymers that, for the specific molecular precursors used, have the radical states observed at the edges of the polymer, as depicted in the polymer of general formula (I).

The method of the invention can be schematically represented by the following non-limiting representation of the exemplary monomer (13,13'-bis(dibromomethylene)-5a,6a, 12a, 13a-tetrahydro-13H, 13'H-6,6'-bipentacenylidene):

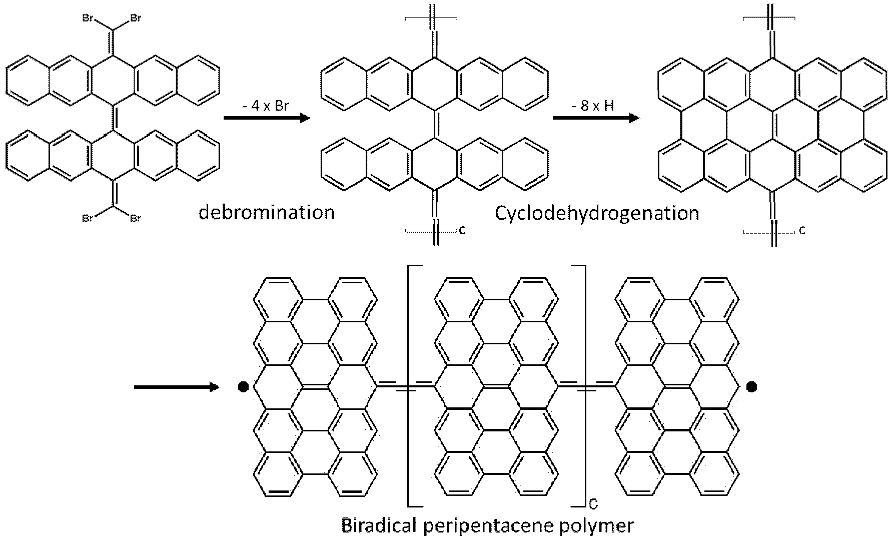

### Monomer of formula (II)

In the method of the invention, in formula (II), the particular embodiments of **R₁, R₂, R₃, R₄, R₅, R₆, R₇, R₈, R₉, R₁₀, R₁₁** and **R₁₂** can also be as defined above for the polymer of formula (I) of the invention.

In the method of the invention, in formula (II), the particular embodiments of the integer a can also be as defined above for the polymer of formula (I) of the invention.

In the method of the invention, in formula (II), the particular embodiments of the integers **b₁, b₂, b₃, b₄, b₅** and **b₆** can also be as defined above for the polymer of formula (I) of the invention.

In the method of the invention, in formula (II), **X₁, X₂, X₃** and **X₄** are independently selected from a leaving group consisting of I, Br, Cl, F, sulfonate, phosphonate, boronate, azo, silane or stannane. In a preferred embodiment, **X₁, X₂, X₃** and **X₄** are independently selected from Br and I. In a most preferred embodiment, **X₁, X₂, X₃** and **X₄** are Br.

In a particular embodiment of the method of the invention, in formula (II), each occurrence of **R₁, R₂, R₃, R₄, R₅, R₆, R₇, R₈, R₉, R₁₀, R₁₁** and R₁₂ is H, OH, -CN, -NO₂, optionally substituted C₁-C₆ alkyl group or optionally substituted C₆-C₁₂ aryl. Preferably, each occurrence of **R₁, R₂, R₃, R₄,** Rₛ, **R₆, R₇, R₈, R₉, R₁₀, R₁₁** and **R₁₂** is H, OH, optionally substituted C₁-C₆ alkyl group or optionally substituted benzene.

In a particular embodiment of the method of the invention, in formula (II), **R₁, R₂, R₃, R₄, R₅, R₆, R₇, R₈, R₉, R₁₀, R₁₁** and **R₁₂** are H.

In another particular embodiment of the method of the invention, in formula (II), the integer a is either selected from 0 or 1. In a preferred embodiment, **a** is 0.

In another particular embodiment of the method of the invention, in formula (II), the integers **b₁, b₂, b₃, b₄, b₅** and **b₆** are independently selected from 0, 1 or 2, preferably from 1 or 2. In a preferred embodiment, **b₁, b₂, b₃, b₄, b₅** and **b₆** are 1.

In another particular embodiment of the method of the invention, in formula (II), **X₁, X₂, X₃** and **X₄** are independently selected from I or Br. In a preferred embodiment, Br.

In a preferred embodiment of the method of the invention, in formula (II), **R₁, R₂, R₃, R₄, R₅, R₆, R₇, R₈, R₉, R₁₀, R₁₁** and **R₁₂** are H, a is 0, 1 or 2, **b₁, b₂, b₃, b₄, b₅** and **b₆** are each independently 1 or 2 and **X₁, X₂, X₃** and **X₄** are Br.

In another preferred embodiment of the method of the invention, in formula (II), **R₁, R₂, R₃, R₄, R₅, R₆, R₇, R₈, R₉, R₁₀, R₁₁** and **R₁₂** are H, **a** is 0, **b₁, b₂, b₅** and **b₆** are each independently 1 or 2 and **X₁, X₂, X₃** and **X₄** are each independently I, Br, Cl or F, preferably Br.

In a preferred embodiment of the method of the invention, in formula (II), **R₁, R₂, R₃, R₄, R₅, R₆, R₇, R₈, R₉, R₁₀, R₁₁** and **R₁₂** are H, **a** is 1 or 2, **b₁, b₂, b₃, b₄, b₅** and **b₆** are each independently 1 or 2 and **X₁, X₂, X₃** and **X₄** are each independently I, Br, Cl or F, preferably Br.

In another preferred embodiment, the method of the invention uses the monomer 13, 13'-bis(dibromomethylene)-5a,6a, 12a, 13a-tetrahydro-13H, 13'H-6,6'-bipentacenylidene of formula (IIa) as molecular precursor in step a). In this particular embodiment, biradical [3,5]-periacene polymers are obtained, with formula (I) wherein **a** is 0 and **b₁, b₂, b₃, b₄, b₅** and **b₆** are 1 and the resulting polymer shows the formation of linear polymers which present an electronic band gap of 1 eV (spectra taken from ½ to ½ of the peaks).

Non-limiting exemplary monomers that fall into the scope of formula (II) are: 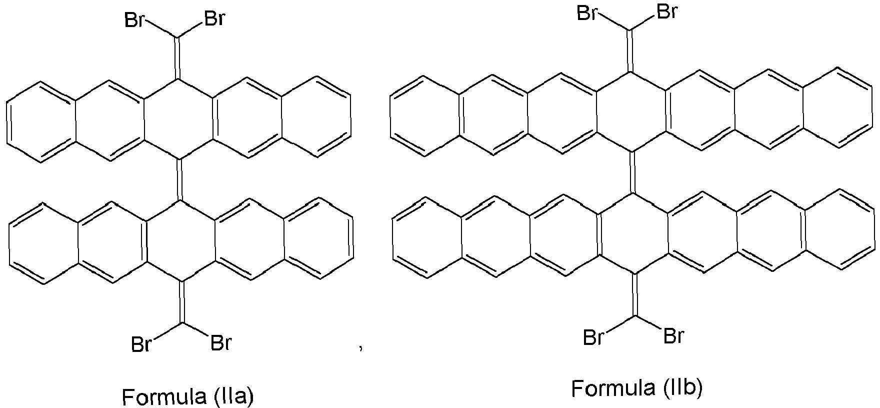 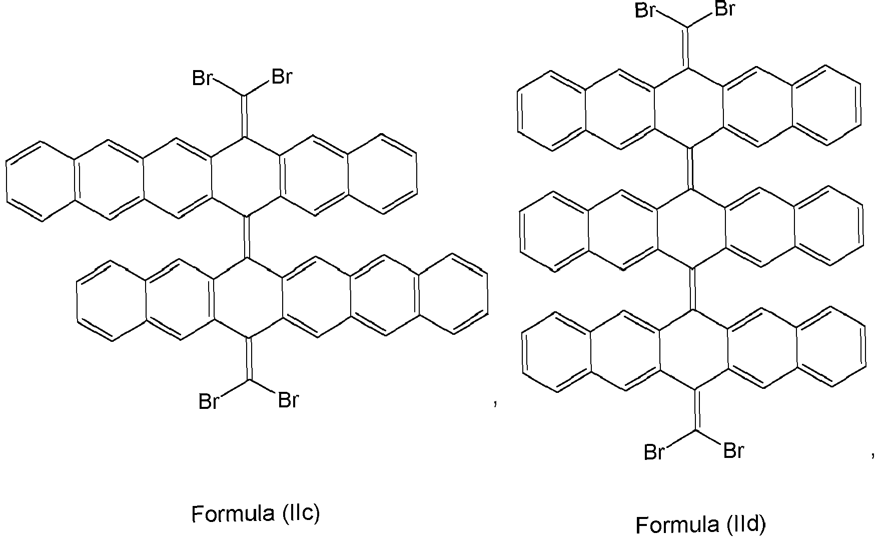 and

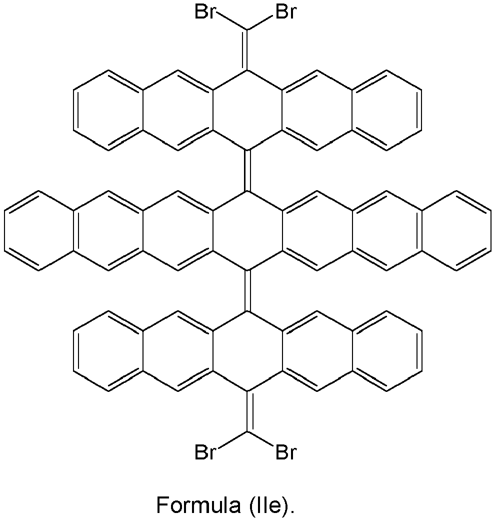

### Step (a)

In the method of the invention, a solid substrate refers to any material suitable for allowing the polymerization of the at least two monomer units provided onto it. Therefore, any solid substrate which allows the adsorption of the at least two monomer units and their consequent polymerization yielding a linear polymer on its surface can be employed. Particularly, the surface of the solid substrate onto which the monomer precursor units are provided is selected from Au, Ag, Cu, Al, Pt, Pd, W, Ni, Si, Ge, GaAs, SiC, MoS₂, BN, NaCl, CaCO₃, silicon oxide, silicon oxynitride, hafnium silicate, nitrided hafnium silicates (HfSiON), zirconium silicate, hafnium dioxide, zirconium dioxide, aluminum oxide, copper oxide, iron oxide, strontium titanate, lead titanate, barium titanate, molybdenum diselenide, molybdenum diteluride, tungsten disulfide, tungsten diselenide, phosphorene or combinations thereof.

In a preferred embodiment, the surface of the solid substrate onto which the monomer precursor units are provided is selected from Au, Ag, Cu, Al, Pt, Pd, Si, Ge, GaAs, SiC, MoS₂, BN, NaCl, CaCO₃ or combinations thereof. In a more preferred embodiment, the surface of the solid substrate onto which the monomer precursor units are provided is selected from Au, Ag, Cu, Al, Pt, Pd or combinations thereof. In an even more preferred embodiment, the surface of the solid substrate onto which the monomer precursor units are provided is selected from Au, Ag, Cu or combinations thereof. Most preferably, the solid substrate's surface is Au.

In a particular embodiment, the solid substrate and the surface of the solid substrate onto which the monomer precursor units are provided is composed of the same material.

In a particular embodiment of the method of the invention, the solid substrate is capable of inducing a unidirectional growth orientation of the polymer. An exemplary feature of such a solid substrate could be Au(110) or vicinal Au(788) or vicinal Au(111212).

The surface of the solid substrate onto which the monomer precursor units are provided can be completely flat, patterned, or stepped.

Preferably, the solid substrate has a flat surface. Such patterned or stepped surfaces and manufacturing methods thereof are known to the skilled person. On patterned surfaces, the growth orientation of the polymer can also be directed by the surface pattern.

Particularly, said surface can also be electrically conducting, semiconducting, or insulating. The surface can be non-magnetic or magnetic (ferro- or anti-ferromagnetic).

The provision of the molecular monomer units on the surface of the solid substrate can be accomplished by any procedure convenient for providing organic compounds on a particular surface. In the method of the invention, step (a) is preferably a step of vacuum deposition (sublimation), spin coating, spray coating, dip coating, printing, electrospray deposition, laser induced desorption or a direct surface-to-surface transfer. In a more preferred embodiment, it is a step of vacuum deposition. More preferably, it is a vacuum sublimation process.

In a particular embodiment of the method of the invention, step (a) is preceded by a first step of surface treatment of the solid substrate. In this sense, the solid substrate surface treatment step ensures a clean substrate surface.

Appropriate methods for obtaining a clean surface of the solid substrate are commonly known to the skilled person. Preferably, the clean surface can be obtained by e.g. ion sputtering, plasma cleaning, and/or thermal annealing (preferably under controlled and/or inert atmosphere), or any combination thereof. Depending on the type of substrate, the annealing temperature can be varied over a broad range, e.g. from 200°C to 1200°C. The clean substrate surface can also be obtained by deposition of a thin layer of the substrate surface material or by cleavage of the substrate, possibly in combination with one or more of the above-mentioned surface treatment steps.

In a particular embodiment, the substrate surface treatment step is carried out at ambient pressure, pressurized ambient such as 10 bar, or at a total gas phase pressure not higher than 1 mbar, 1×10⁻¹ mbar, not higher than 1×10⁻² mbar, not higher than 1×10⁻³ mbar, not higher than 1×10⁻⁴ mbar, not higher than 1×10⁻⁵ mbar, not higher than 1×10⁻⁶ mbar, not higher than 1×10⁻⁷ mbar, not higher than 1×10⁻⁸ mbar and preferably not higher than 1×10⁻⁹ mbar.

### Step (b)

This step comprises the polymerization step, wherein the molecular precursor (monomer units) deposited on the surface polymerizes so as to form at least one polymer on the surface which is preferably linear, on the surface of the solid substrate. Appropriate conditions for effecting polymerization of the molecular precursor are typically known by the skilled person. In this sense, any energy input which induces polymerization of the molecular monomer units can be used, non-limiting examples being temperature, electromagnetic radiation, electric currents and electric fields.

In a particular embodiment, the polymerization step (b) is induced by thermal activation. The temperature required for inducing polymerization will depend on the particular structure of the monomers as will be readily understood by the skilled person. In a particular embodiment, step (b) is conducted at a temperature comprised between -100 and 500°C, more preferably between 0 and 500°C, more preferably between 50°C and 500°C, even more preferably between 50°C and 300°C. In a most preferred embodiment, the polymerization step (b) is conducted between 100°C and 300°C.

In a particular embodiment, the polymerization step is carried out at ambient pressure, pressurized ambient such as 10 bar, or at a total gas phase pressure not higher than 1 mbar, 1×10⁻¹ mbar, not higher than 1×10⁻² mbar, not higher than 1×10⁻³ mbar, not higher than 1×10⁻⁴ mbar, not higher than 1×10⁻⁵ mbar, not higher than 1×10⁻⁶ mbar, not higher than 1×10⁻⁷ mbar, not higher than 1×10⁻⁸ mbar and preferably not higher than 1×10⁻⁹ mbar.

### Step (c)

This step comprises the cyclodehydrogenation step, wherein the polyacenes found in the repeating units of the polymer that resulted from the polymerization step (b) cyclize. Generally, optimal reaction conditions for cyclodehydrogenation are known by the skilled person.

In a particular embodiment of the method of the invention, step (c) of partially cyclodehydrogenating the polymer is performed at a total gas phase pressure not higher than 1×10⁻¹ mbar, not higher than 1×10⁻² mbar, not higher than 1×10⁻³ mbar, not higher than 1×10⁻⁴ mbar, not higher than 1×10⁻⁵ mbar, not higher than 1×10⁻⁶ mbar, not higher than 1×10⁻⁷ mbar, not higher than 1×10⁻⁸ mbar and preferably not higher than 1×10⁻⁹ mbar.

In another preferred embodiment of the method of the invention, step (c) is performed at a total gas phase pressure between 1×10⁻⁹ mbar and 1×10⁻¹¹ mbar.

In a particular embodiment of the method of the invention, step (c) of partially cyclodehydrogenating the polymer is also induced by thermal activation. The temperature required for inducing cyclodehydrogenation will depend on the particular structure of the monomers as will be readily understood by the skilled person. In a particular embodiment, step (c) is induced by thermal activation at a temperature which is preferably higher than the temperature of step (b), but not higher than 600°C. In a preferred embodiment, the temperature of step (c) is comprised between 100°C and 600°C, between 200°C and 600°C, more preferably between 300°C and 600°C, most preferably between 300°C and 450°C.

In a particular embodiment of the method of the invention, step (c) is a step of fully cyclodehydrogenating the polymer.

At this stage of annealing, the two termini of the polymers have already lost the remaining carbon and are passivated by residual atomic hydrogen.

### Pressure and Temperature

In the method of the invention, any of steps (a), (b) and/or (c) can be carried out at ambient pressure. In a particular embodiment of the method of the invention, any of steps (a), (b) and/or (c) are carried out at a total gas phase pressure comprised between 1×10⁻¹ mbar and 1×10⁻¹¹ mbar. Preferably, steps (a), (b) and/or (c) are carried out at a total gas phase pressure comprised between 1×10⁻³ mbar and 1×10⁻¹¹ mbar, more preferably between 1×10⁻⁶ mbar and 1×10⁻¹⁰ mbar, most preferably between 1×10⁻⁹ mbar and 1×10⁻¹¹ mbar.

The total gas phase pressure can be measured by techniques typically known to the skilled person, for example a commercially available Agilent's UHV-24 Bayard-Alpert Gauge which uses hot-cathode ionization gauge tubes with heated filament for the source of electrons.

In the method of the invention, steps (a) and (b) can also be carried out at room temperature, which in this context is a temperature comprised between 15°C and 30°C.

The invention further contemplates the use of the monomer of formula (II) for the synthesis of a π-conjugated polymer. In particular, the use of the monomer of formula (II) for the synthesis of a π-conjugated polymer of formula (I).

### Polymer obtainable according to the method of the invention.

In a third aspect of the invention, a π-conjugated polymer obtainable according to the method of the second aspect of the invention is provided.

The polymer obtainable according to the method of the invention is inherently a polymer with the technical features of the polymer of formula (I) of the invention as described above for the first aspect of the invention.

Preferably, the polymer obtainable according to the method of the invention is a polymer of formula (I), wherein at least one of **b₁** + **b₂, b₃ + b₄** or **b₅** + **b₆** is ≥ 2.

In other words, the polymer obtainable according to the method of the invention is preferably a polymer wherein at least one of the periacene monomer units comprises at least five benzene fused rings in the transverse direction. In this context, the transverse direction is the direction orthogonal to the length of the polymer. The zigzag type carbons are along the transverse direction.

In yet another preferred embodiment, the π-conjugated polymer obtainable according to the method of the invention is a polymer with a band gap comprised between 0.01 eV and 2 eV. Typically, the band gap can be measured using Scanning Tunneling Spectroscopy (STS).

### Technical Effect

The polymer of the invention has a surprisingly low band gap and has an open-shell electronic density, where one unpaired electron is found at each of the two ends of the polymer.

In the context of the present invention, the term "low band gap" refers to a value which is equal to or less than 2 eV, preferably equal to or less than 1.5 eV.

The polymer of the present invention was studied by combining density functional theory (DFT) and scanning tunneling spectroscopy (STS) methods. The inventors have found that the band gap of the polymer of the invention appears to be determined by the width and length of the periacene units that form it. In turn, the width and length of the periacene units depend on the structure of the molecular precursors.

In a particular embodiment, the polymer has a band gap in the range of from 0.01 eV to 2 eV, preferably of from 0.5 eV to 1.8 eV, more preferably of from 0.7 eV to 1.5 eV. In yet another particular embodiment, the polymer has a band gap in the range of from 0.01 eV to 2.00 eV, preferably of from 0.5 eV to 1.80 eV, more preferably of from 0.70 eV to 1.50 eV. Typically, the band gap can be measured using Scanning Tunneling Spectroscopy (STS).

Said electronic band gap range appears to depend on which molecular precursors are used, in particular on their width, which ranges between 1 nm and 3 nm, preferably between 1.4 nm to 2.5 nm. As shown in the example section, the radical states observed at the edges of the polymers are confirmed by STS and it was observed that these are surprisingly independent of the length of the polymer.

In the polymer of the invention all monomers are bridged by cumulene (=C=C=) bonds and the band gap is low. In addition, the polymer is defect-free. Without wishing to be bound by theory, the inventors believe these factors may influence the preference of the unpaired electron towards the termini of the polymer. As shown in the examples, comparative acene-based polymers have ethynylene bridges and fail to show localized biradical character.

### Uses

In a fourth aspect, the invention is directed at the use of the π-conjugated polymer of the invention, in semi-conductors, light-emitting devices, photovoltaics, organic field-effect transistors, photocatalysis, sensors, organic spintronics, near infrared, nonlinear optics and topological quantum memories.

Therefore, any device such as a semi-conductor, a LED, a photovoltaic cell, a transistor, a catalyst or sensors such as a biosensors, is a device that falls within the scope of the present invention, as long as it comprises the π-conjugated polymer of the invention.

Advantageously, the atomically precise stable biradical polymers of the invention have a structure with remarkable features affording open-shell electronic properties, which can be employed with combined electronic applications not previously reported in the prior art. For example, the biradical polymer structure of the present invention is suitable for electronic transport applications as well as for organic spintronics and molecular sensing. In particular, the simultaneous electronic and sensing functionalities enable the realization of novel device architectures that combine gate control and chemical sensing, such as field-effect transistor (FET) sensors. In addition biradical materials could be used in topological quantum memories.

A particular example of an application is the preparation of OFETs as described in Rudebusch, G., Zafra, J., Jorner, K. et al. Diindeno-fusion of an anthracene as a design strategy for stable organic biradicals. Nature Chem 8, 753-759 (2016*).*

In a non-limiting exemplary way, field-effect transistors may be fabricated by vapor deposition of the polymers of the invention on surfaces such as p-doped Si (001) wafers with a SiO₂ dielectric layer. Prior to deposition, the silicon wafers can be optionally cleaned following methods known to those skilled in the art, such as plasma. Optionally, self-assembled monolayers of either hexamethyldisilazane or octadecyltrichlorosilane can be deposited to reduce charge trapping and thus enhance mobility. Top contact OFETs may then be fabricated by, for example, vapor deposition of Au electrodes onto the semiconductor thin films. This process can be performed through template shadow masks to obtain templated devices.

Additionally, if necessary, the biradical polymers of the invention can also be stabilized by the addition of compounds known to the skilled person in the art such as grafting on SiO₂ or interaction with transition metal atoms.

### EXAMPLES

The present invention will now be described by way of examples which serve to illustrate the construction and testing of illustrative embodiments. However, it is understood that the present invention is not limited in any way to the examples below.

### Example 1. Synthesis of a biradical [3,5]-periacene polymer

An exemplary polymer according to the invention was prepared following the method of the invention.

In this way, a solid substrate (Au(111) surface) was first introduced in a vacuum chamber equipped with an ion source and cleaned with Ar+ ions (1.5 keV; 10 µA; 10 min) and subsequent annealing at 723 K (449,85°C) under UHV (at a total gas phase pressure in chamber of 1×10⁻¹⁰ mbar). The [3,5]-periacene 13,13'-bis(dibromomethylene)-5a,6a,12a,13a-tetrahydro-13H,13'H-6,6'-bipentacenylidene (depicted above as formula (IIa)) was deposited on the Au(111) surface at 25°C (at a pressure of 4×10⁻¹⁰) by sublimation from a quartz crucible to the substrate's surface.

The [3,5]-periacene precursor provided on the Au(111) surface was then polymerized via dehalogenation and subsequent C-C coupling at a temperature of 100°C for 20 mins.

Finally, the cyclodehydrogenation of the polymer was carried out at 180°C.

The resulting polymerized and cyclodehydrogenated sample was characterized by means of STM pictures and STS at 4.5 K, thus revealing that the polymer of the invention is a defect-free linear polymer comprising the periacene monomers bridged by cumulene-type bonds (=C=C=) and that the electronic structure of the polymers is indeed biradical, wherein each of the two lone electrons is located at each terminal monomer of the polymer.

The results are illustrated in Figures 1, 2 and 3. The STM pictures provide unequivocal evidence that a radical appears stabilized in the termini of the polymers, regardless of their length (i.e., number of monomers, integer c). In figure 2, the sharp peak centre at zero bias (curve 1) reveals the radical character at the ends of the polymers comprising three monomers (trimer). The inventors have observed the same radical character at the ends of polymers of other lengths.

In addition, non-contact AFM measurements (shown in Figure 4) of the polymers of the invention confirm that the bonds bridging each monomer are indeed cumulene bonds. In Figure 4, no ethylene bonds are observed.

Electronic band gap values of 1.04 eV were measured by means of Scanning tunnelling spectroscopy.

### Example 2. Synthesis of a comparative periacene polymer

For comparative purposes, different polymers were prepared following the method of the invention but starting from different monomer periacene structures.

The same method as described in Example 1 was followed but using the monomer 11,11,12,12-tetrabromoanthraquinodimethane instead. This monomer has a single acene moiety per monomer and the resulting polymer has the following structure, wherein n is the number of repeating units.

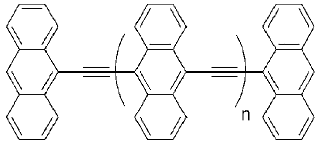

Non-contact AFM measurements of the resulting polymers show that, contrary to the polymer of the invention, this polymer has ethylene bridging bonds (identified as bright spots in the AFM image of Figure 5).

Additionally to the previous comparative example, a further polymer was prepared using monomers comprising not three but five fused acene units. This monomer has a single acene moiety per monomer.

Non-contact AFM measurements of the resulting polymers show that, contrary to the polymer of the invention, this comparative polymer has ethylene bridging bonds (identified as bright spots in the AFM image of Figure 6b, particularly the three topmost monomers of Fig. 6b). Furthermore, STM (Figure 6a) and STS (Figure 6c) measurements both confirm that this comparative polymer does not yield a biradical localized at the termini of the polymer. STM imaging reveals bright spots evident in all monomers of the polymer, contrary only at the terminal ends.

Figure 6c clearly shows that upon measuring at particular points of different monomers as shown in Figure 6b, the radical state is more or less intense but present in all measured points. The sharp peaks centred at zero bias (curves 3 to 8) reveal the radical character at each of the monomers of the comparative polymer. This is opposite to what is shown for the polymer of the invention in Figure 2.

## Claims

1. A π-conjugated polymer of formula (I): 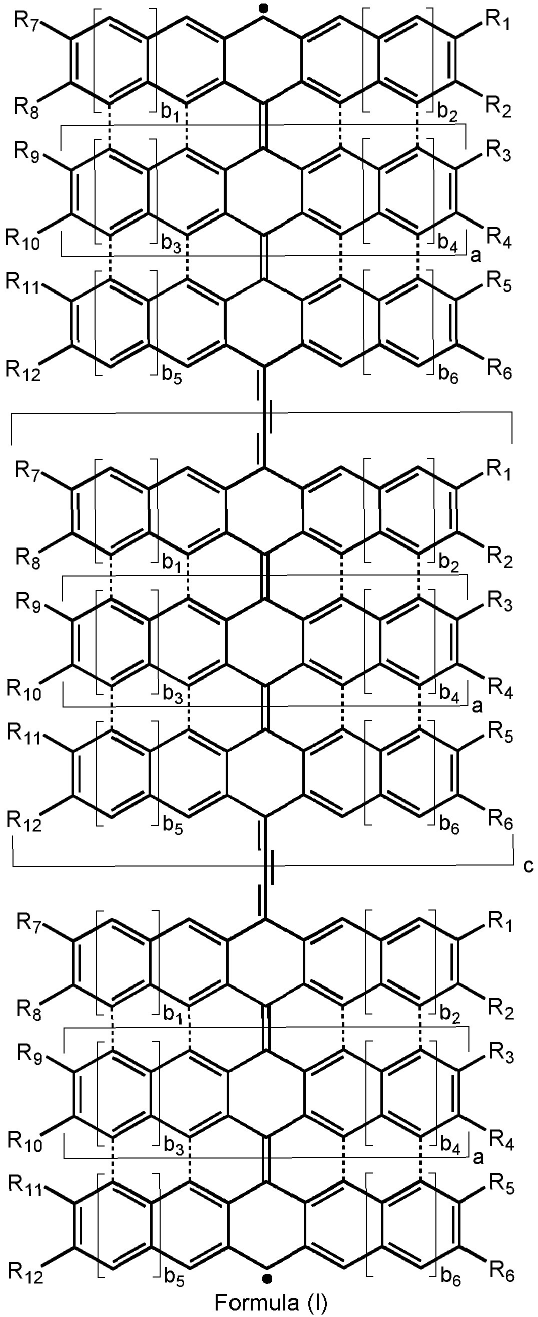 wherein,
each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl;
each occurrence of the integer a is independently selected from 0, 1 or 2;
each occurrence of the integers **b₁, b₂, b₃, b₄, b₅** and **b₆** is independently selected from 0, 1, 2, 3 or 4 wherein **b₁** + **b₂** is ≤ 4, **b₃ + b₄** is ≤ 4, **b₅** + **b₆** is ≤ 4 and **b₁** + **b₂** + **b₃** + **b₄** + **b₅** + **b₆** > 0;
c is an integer comprised between 0 and 100;
each occurrence of the dashed bonds inside each monomer unit is independently a bond or absence of a bond; and
each circular dot depicted next to the terminal carbon atoms represents one unpaired electron.

2. The π-conjugated biradical polymer according to claim 1, wherein at least one of **b₁** + **b₂, b₃** + **b₄** or **b₅** + **b₆** is ≥ 2.

3. The π-conjugated biradical polymer according to any one of claims 1 or 2, wherein each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN, -NO₂, optionally substituted C₆-C₁₂ aryl and optionally substituted 3- to 10-membered heteroaryl.

4. The π-conjugated biradical polymer according to any one of claims 1 to 3, wherein each occurrence of **R₁, R₂, R₃, R₄, R₅, R₆, R₇, R₈, R₉, R₁₀, R₁₁** and **R₁₂** is independently selected from the group consisting of H, OH, I, Br, Cl, F, -CN and - NO₂.

5. A method for the synthesis of a π-conjugated polymer comprising the steps of:
a. providing, on a solid substrate, at least two polycyclic aromatic hydrocarbon monomer precursor units of formula (II), 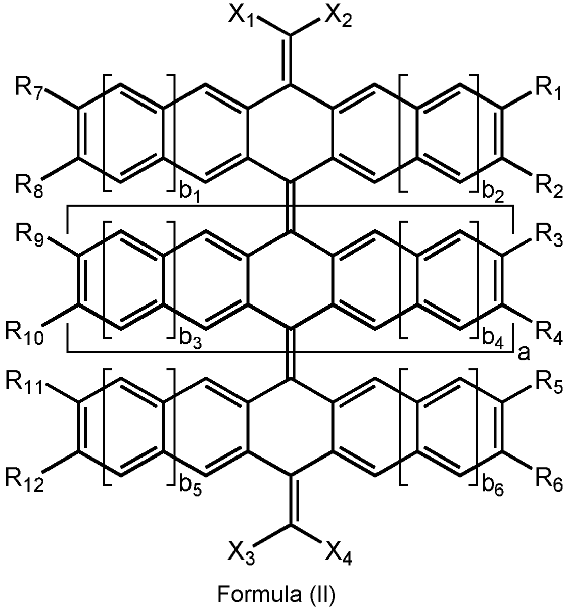 wherein,
**R₁, R₂, R₃, R₄, R₅, R₆, R₇, R₈, R₉, R₁₀, R₁₁** and **R₁₂** are independently selected from the group consisting of H, OH, I, Br, Cl, F, -CN, -NO₂, optionally substituted C₁-C₆ alkyl group, optionally substituted C₃-C₇ saturated or partially saturated mono- or bicyclic aliphatic group, optionally substituted 3- to 10-membered heterocyclyl, optionally substituted C₆-C₁₂ aryl, optionally substituted (C₆-C₁₂)aryl(C₁-C₆)alkyl, and optionally substituted 3- to 10-membered heteroaryl;
the integer **a** is selected from 0, 1 or 2;
the integers **b₁, b₂, b₃, b₄, b₅** and **b₆** are independently selected from 0, 1, 2, 3 or 4 wherein **b₁** + **b₂** is ≤ 4, **b₃** + **b₄** is ≤ 4, **b₅** + **b₆** is ≤ 4 and **b₁** + **b₂** + **b₃** + **b₄** + **b₅ + b₆** > 0; and
**X₁, X₂, X₃** and **X₄** is independently selected from a leaving group consisting of I, Br, Cl, F, sulfonate, phosphonate, boronate, azo, silane or stannane, preferably Br;
b. polymerizing the monomer precursor of the previous step on the solid substrate by dehalogenation and subsequent C-C coupling; and
c. at least partially cyclodehydrogenating the polymer obtained in the previous step.

6. The method according to claim 5, wherein the surface of the solid substrate onto which the precursor of formula (II) is provided, is a surface comprising Au, Ag, Cu, Al, Pt, Pd, W, Ni, Si, Ge, GaAs, SiC, MoS₂, BN, NaCl, CaCO₃, silicon oxide, silicon oxynitride, hafnium silicate, nitrided hafnium silicates (HfSiON), zirconium silicate, hafnium dioxide, zirconium dioxide, aluminum oxide, copper oxide, iron oxide, strontium titanate, lead titanate, barium titanate, molybdenum diselenide, molybdenum diteluride, tungsten disulfide, tungsten diselenide, phosphorene or combinations thereof.

7. The method according to any one of claims 5 or 6, wherein the surface of the solid substrate onto which the precursor of formula (II) is provided, is a surface selected to induce a unidirectional growth orientation of the polymer.

8. The method according to any one of claims 5 to 7, wherein in step (a), the provision of the monomer precursor on a solid substrate is performed by vacuum deposition, spin coating, spray coating, dip coating, printing, electrospray deposition, laser induced desorption or a direct surface-to-surface transfer.

9. The method according to any one of claims 5 to 8, wherein steps (a), (b) and (c) are carried out at a total gas phase pressure comprised between 1×10⁻¹ and 1×10⁻¹¹ mbar.

10. The method according to any one of claims 5 to 9, wherein step (b) is induced by thermal activation at a temperature comprised between -100 and 500°C.

11. The method according to any one of claims 5 to 10, wherein step (c) is induced by thermal activation at a temperature which is higher than the temperature of step (b), but not higher than 600°C.

12. A π-conjugated polymer obtainable according to the method of any one of claims 5 to 11.

13. The π-conjugated polymer according to claim 12, wherein at least one of the periacene monomer units comprises at least five benzene fused rings in the transverse direction.

14. The π-conjugated polymer according to any one of claims 1 to 4, or according to any one of claims 12 or 13, wherein the polymer has a band gap comprised between 0.01 eV and 2 eV.

15. Use of the π-conjugated polymer according to any one of claims 1 to 4, or according to any one of claims 12 or 13, in semi-conductors, light-emitting devices, photovoltaics, organic field-effect transistors, photocatalysis, sensors, organic spintronics, near infrared, nonlinear optics and topological quantum memories.
